(19) Europäisches Patentamt
European Patent Office
Office européen des brevets

(11) **EP 0 740 838 B1**

(12) **EUROPÄISCHE PATENTSCHRIFT**

(45) Veröffentlichungstag und Bekanntmachung des Hinweises auf die Patenterteilung:
**08.07.1998 Patentblatt 1998/28**

(21) Anmeldenummer: **95906274.6**

(22) Anmeldetag: **18.01.1995**

(51) Int Cl.$^6$: **G11C 29/00**

(86) Internationale Anmeldenummer:
**PCT/DE95/00100**

(87) Internationale Veröffentlichungsnummer:
**WO 95/20226 (27.07.1995 Gazette 1995/32)**

(54) **VERFAHREN ZUM TEST VON DIGITALEN SPEICHEREINRICHTUNGEN**

PROCESS FOR TESTING DIGITAL STORAGE DEVICES

PROCEDE POUR TESTER DES DISPOSITIFS A MEMOIRES NUMERIQUES

(84) Benannte Vertragsstaaten:
**DE FR GB IT NL**

(30) Priorität: **21.01.1994 DE 4402122**

(43) Veröffentlichungstag der Anmeldung:
**06.11.1996 Patentblatt 1996/45**

(73) Patentinhaber: **TEKTRONIX, INC.**
**Wilsonville, Oregon 97070-1000 (US)**

(72) Erfinder: **KOLBINGER, Josef**
**D-84061 Ergoldsbach (DE)**

(74) Vertreter: **Hofstetter, Alfons J., Dr.rer.nat. et al**
**Strasse & Hofstetter,**
**Balanstrasse 57**
**81541 München (DE)**

(56) Entgegenhaltungen:
**US-A- 4 061 908**

• **IBM TECHNICAL DISCLOSURE BULLETIN., Bd.32, Nr.1, Juni 1989, NEW YORK US Seiten 220 - 224 'Method for address fault detection'**
• **IBM TECHNICAL DISCLOSURE BULLETIN., Bd.31, Nr.10, März 1989, NEW YORK US Seiten 61 - 63 'Nonvolatile RAM failure rate reduction through the use of redundancy'**

**Beschreibung**

Die Erfindung betrifft ein Verfahren zum Test von digitalen Speichereinrichtungen, bei dem

- jeder Speicherzelle der digitalen Speichereinrichtung eine bestimmte Zahl zugeordnet wird, wobei die Menge der wählbaren Zahlenwerte durch die Stellenanzahl der Speicherzellen festgelegt ist, und die Zuordnung der Zahlenwerte so erfolgt, daß aus einer Zahlenfolge aus mehreren im Adreßbereich aufeinanderfolgenden Speicherzellen auf die Adresse der Speicherzellen geschlossen werden kann,
- die Speicherzellen der digitalen Speichereinrichtung mit den ihnen jeweils zugeordneten Zahlenwerten beschrieben werden,
- die Speicherzellen ausgelesen werden und der ausgelesene Zahlenwert mit dem jeweils zugeordneten Zahlenwert verglichen wird und
- bei Nichtübereinstimmung von ausgelesenem Zahlenwert und zugeordnetem Zahlenwert eine Fehlermeldung generiert wird.

Ein solches Verfahren ist aus der IMB TECHNICAL DISCLOSURE BULLETIN, Bd. 32, Nr. 1, Juni 1989, NEW YORK, USA, Seite 220;"Method for address fault detection" bekannt. Bei diesem Verfahren werden zwei Zahlen zum Überprüfen eines Speichers mit vier 1-Bit breiten Speicherzellen verwendet; jeder Speicherzelle wird eine der Zahlen 0 oder 1 zugeordnet und aus der Reihenfolge der zugeordneten Zahlen mehrerer im Adreßbereich aufeinanderfolgenden Speicherzellen kann auf die Adresse der Speicherzelle geschlossen werden. Die zugeordneten Zahlen werden in die jeweilige Speicherzelle geschrieben, wobei nacheinander alle vier Speicherzellen des gesamten Speichers beschrieben werden, angefangen von der Speicherzelle mit der kleinsten Adresse bis zur Speicherzelle mit der größten Adresse. Die Speicherzellen werden anschließend ausgelesen und der Speicherinhalt mit der jeweils zugeordneten Zahl verglichen. Ein Unterschied zwischen dem ausgelesenen Speicherinhalt und der zugeordneten Zahl läßt auf einen Adressierungs- oder einen Speicherungsfehler zurückschließen. Die zugeordneten Zahlen werden anschließend nochmals gespeichert, wobei diesmal bei der größten Adresse angefangen wird. Die Speicherzellen werden danach wieder ausgelesen und der Speicherinhalt mit der zugeordneten Zahl auf Übereinstimmung überprüft.

Bei einem anderen bekannten Verfahren erfolgt der Test der digitalen Speichereinrichtung so, daß in jede Speicherzelle die Adresse dieser Zelle eingeschrieben wird und danach der Speicher wieder ausgelesen wird. Durch Vergleich der jeweils angelegten Adresse mit dem ausgelesenen Speicherinhalt, der dieser Adresse entsprechen muß, können auftretende Fehler festgestellt werden. Dies ist aufgrund der hohen Speicherkapazität vieler Schaltungen ein aufwendiger Vorgang.

Nun treten bei gedruckten Leiterplatten, der häufigsten Ausführungsform moderner Schaltungen, besonders häufig Kurzschlüsse zwischen benachbarten Leiterbahnen auf. Im Falle von auf Leiterplatten angeordneten Speichern führt dies oftmals dazu, daß Adressierungsfehler auftreten. Es werden also die Daten an falsche Speicherzellen geschrieben bzw. kommt es zu Mehrfachzugriffen auf einzelne Speicherzellen unter verschiedenen Adressen. Derartige Adressierungsfehler sind mit den genannten Speichertests nicht immer erkennbar.

Der Erfindung liegt nun die Aufgabe zugrunde, ein Verfahren anzugeben, mit dem bei digitalen Speichereinrichtungen mit mehreren Adreßbits umfassenden Speicherzellen oben genannte Adressierungsfehler erkannt werden können. Erfindungsgemäß geschieht dies bei einem Verfahren der eingangs erwähnten Art, indem bei einer digitalen Speichereinrichtung mit jeweils vier Adreßbits umfassenden Speicherzellen die Zuordnung der Zahlenwerte zu den Speicherzellen gemäß

$$Z = ADR\,(0,1,...S\text{-}1)\ XOR\ ADR(S,...N)$$

mit

Z = Zahlenwert in Binärdarstellung
ADR = Adresse der Speicherzelle in Binärstellung
N = Anzahl der Adreßbits der Speicherzelle minus eins
und
S = 2 = Stellenzahl der Speicherstelle

erfolgt.

Die Erfindung wird anhand von zwei Figuren näher erläutert. Es zeigen beispielhaft:

Figur 1 eine übliche elektronische Schaltung und
Figur 2 die Codierung von Testdaten.

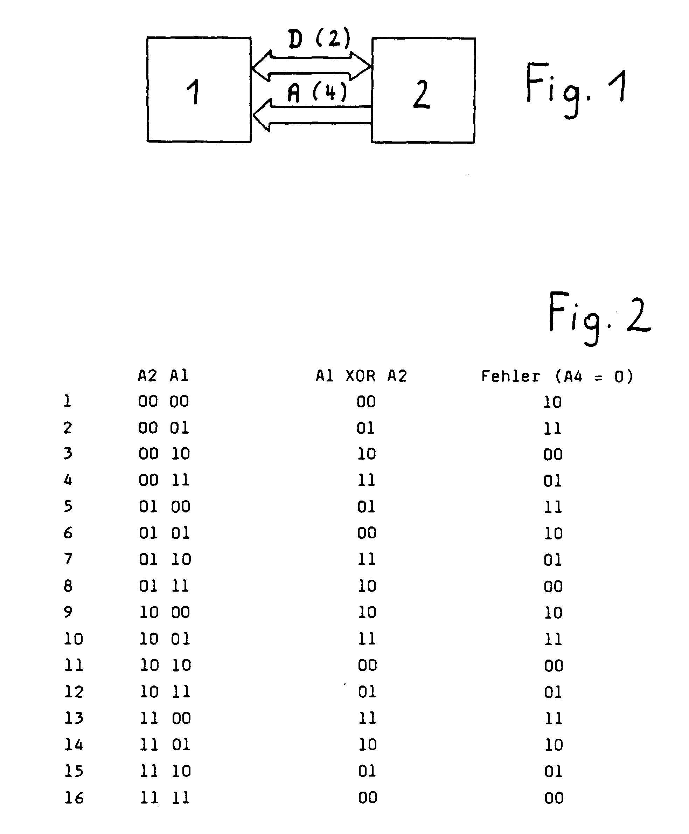

Die in Figur 1 dargestellte elektronische Schaltung umfaßt einen Speicher 1 und einen Mikroprozessor 2. Die Verbindung zwischen den beiden Funktionsgruppen bildet ein Bus-System bestehend aus einem Adreßbus A mit vier Datenleitungen und einem Datenbus D mit zwei Datenleitungen.

Die beiden Datenleitungen entsprechen der Breite einer Speicherstelle von zwei Bit. Der gesamte Speicher besitzt $2^4$ =16 unterschiedliche Speicherzellen. Es ist nun nicht möglich, diese 16 unterschiedlichen Speicherzellen mit den nur zwei Datenleitungen mit insgesamt vier darstellbaren Zuständen eindeutig zu codieren.

Bei herkömmlichen Testverfahren wird daher nur ein Teil der Adreßinformation in die Speicherzellen geschrieben, beispielsweise die zwei niedrigstwertigen Adreßbits. Mit diesem Testverfahren können jedoch Adressierungsfehler, die aufgrund eines Kurzschlusses der beiden oberen Adreßleitungen entstehen, nicht erkannt werden, da z.B. die Speicherzellen 1, 5, 9 und 13 die gleiche Information enthalten, und sich ein derartiger Adressierungsfehler so auswirkt, daß anstelle der Speicherzellen 1 beispielsweise die Speicherzelle 5 oder 9 beschrieben wird.

Nach der Erfindung werden nicht die reinen Adreßinformationen in die Speicherzellen eingeschrieben, sondern die Adreßinformation der beiden niedrigwertigen Adreßleitungen wird verknüpft mit der Adreßinformation der beiden höherwertigen Adreßleitungen. Dies geschieht über die logische Verknüpfung A1 XOR A2. Das Ergebnis dieser Verknüpfung ist in Figur 2 dargestellt. Wie aus der Figur 2 ersichtlich, ist die Reihenfolge der Zahlenwerte bei den Adressen 1 - 4 bzw. 5 - 8 usw. unterschiedlich. Aus dieser unterschiedliche Reihenfolge kann daher auf die Lage der Speicherzelle im gesamten Adreßraum geschlossen werden. Damit ist aber auch die Feststellung von Fehlern der oben beschriebenen Art möglich. Wenn beispielsweise ein Kurzschluß der obersten Adreßleitung gegeben ist, wird bei dem Speichertest die Information der Zellen 13 - 16 an die Stelle der Zellen 5 - 8 geschrieben. Die ursprüngliche Information dieser Zellen wird daher überschrieben. Beim Auslesen des Speichers ergibt sich daher das in Figur 2 in der Spalte Fehler angegebene Bild. Die Reihenfolge der ausgelesenen Datenwerte stimmt also für die Speicherzellen 1 - 8 und 9 - 16 überein. dies ist ein eindeutiger Hinweis darauf, daß die vierte Adreßleitung defekt ist. Die Fehlersuche ist somit erheblich erleichtert.

**Patentansprüche**

1. Verfahren zum Test von digitalen Speichereinrichtungen mit folgenden Verfahrensschritten:

   - jeder Speicherzelle der digitalen Speichereinrichtung wird eine bestimmte Zahl zugeordnet, wobei die Menge der wählbaren Zahlenwerte durch die Stellenanzahl der Speicherzellen festgelegt ist, und die Zuordnung der Zahlenwerte so erfolgt, daß aus einer Zahlenfolge aus mehreren im Adreßbereich aufeinanderfolgenden Speicherzellen auf die Adresse der Speicherzellen geschlossen werden kann,

   - die Speicherzellen der digitalen Speichereinrichtung mit den ihnen jeweils zugeordneten Zahlenwerten beschrieben werden,

   - die Speicherzellen ausgelesen werden und der ausgelesene Zahlenwert mit dem jeweils zugeordneten Zahlenwert verglichen wird und

   bei Nichtübereinstimmung von ausgelesenem Zahlenwert und zugeordnetem Zahlenwert eine Fehlermeldung generiert wird,
   **dadurch gekennzeichnet**, daß

   - bei einer digitalen Speichereinrichtung mit jeweils vier Adreßbits umfassenden Speicherzellen die Zuordnung der Zahlenwerte zu den Speicherzellen gemäß

   $$Z = ADR\ (0,\ 1,...\ S-1)\ XOR\ ADR\ (S,...N)$$

   mit

   | | |
   |---|---|
   | Z = | Zahlenwert in Binärdarstellung |
   | ADR = | Adresse der Speicherzelle in Binärdarstellung |
   | N = | Anzahl der Adreßbits der Speicherzelle minus eins und |
   | S = | 2 = Stellenzahl der Speicherstelle |

   erfolgt.

**Claims**

1. Method for testing digital storage means comprising the following procedural steps:

   - each of the storage cells of the digital storage means is assigned a certain number, with the set of numerical values to be chosen from being determined by the number of digits of the storage cells and the assignment of the numerical values being effected in such a way that the address of the storage cells can be derived from a sequence of numbers of several successive storage cells within the addressing area,

   - with the storage cells of the digital storage means being described by the respective numerical values assigned to them,

   - with the storage cells being read-out and the read-out numerical value being compared with the respective assigned numerical value and in case of a non-match of the read-out numerical value and the assigned numerical value an error message being generated,

   **characterized in that**

   - in a digital storage means with storage cells each comprising four address bits assignment of the numerical values to the storage cells is carried out according to

$$Z = ADR\ (0,1,...S\text{-}1)\ XOR\ ADR\ (S,...N)$$

with

| | |
|---|---|
| Z = | numerical value in binary-coded notation |
| ADR = | address of the storage cell in binary-coded notation |
| N = | number of the address bits of the storage cell less one and |
| S = | 2 = digit number of the storage location. |

| | |
|---|---|
| S = | 2 = position du nombre du champ de mémoire. |

**Revendications**

1. Procédé de vérification de dispositifs de mémoires numériques selon les étapes suivantes:

   - à chaque cellule de mémoire du dispositif de mémoire numérique on attribue un nombre précis, dont le choix est restreint par le nombre maximum de valeurs représentables par chaque cellule, et l'attribution de ces valeurs se fait de sorte que l'on puisse conclure, de l'ordre des chiffres attribués à plusieurs cellules de mémoire consécutives dans le champ d'adresse, l'adresse des cellules de mémoire,

   - que l'on décrive chaque cellule de mémoire du dispositif de mémoire numérique, y compris les valeurs qui leur sont attribuées,

   - que l'on lise les cellules de mémoire et que l'on compare la valeur lue avec la valeur antérieurement attribuée, et que lorsque la valeur lue diffère de la valeur antérieurement attribuée, un message d'erreur soit émis, caractérisant que

   - dans un dispositif de mémoire numérique dont les cellules de mémoire couvrent chacune quatre bits d'adresse, l'attribution des valeurs aux cellules de mémoire se fait de la manière:

   $$Z = ADR\ (0,\ 1,\ ...\ S\text{-}1)\ XOR\ ADR\ (S,\ ...\ N)$$

   avec

   | | |
   |---|---|
   | Z = | la valeur codée binaire |
   | ADR = | l'adresse de la cellule de mémoire, codée binaire |
   | N = | le nombre des bits du champ d'adresse de la cellule de mémoire moins un et |

Fig. 1

Fig. 2

|    | A2 A1 | A1 XOR A2 | Fehler (A4 = 0) |
|----|-------|-----------|-----------------|
| 1  | 00 00 | 00        | 10              |
| 2  | 00 01 | 01        | 11              |
| 3  | 00 10 | 10        | 00              |
| 4  | 00 11 | 11        | 01              |
| 5  | 01 00 | 01        | 11              |
| 6  | 01 01 | 00        | 10              |
| 7  | 01 10 | 11        | 01              |
| 8  | 01 11 | 10        | 00              |
| 9  | 10 00 | 10        | 10              |
| 10 | 10 01 | 11        | 11              |
| 11 | 10 10 | 00        | 00              |
| 12 | 10 11 | 01        | 01              |
| 13 | 11 00 | 11        | 11              |
| 14 | 11 01 | 10        | 10              |
| 15 | 11 10 | 01        | 01              |
| 16 | 11 11 | 00        | 00              |